# EUROPEAN PATENT APPLICATION

(11) **EP 2 407 403 A1**
(43) Date of publication of application: **18.01.2012**
(21) Application number: 10837467.9
(22) Date of filing: 07.12.2010
(51) Int. Cl.: B65H 23/038, B65H 23/025, H01L 31/04, H01L 51/50, H05B 33/10

(54) **APPARATUS FOR CONTROLLING POSITION OF FLEXIBLE SUBSTRATE**

(30) Priority: 16.12.2009 JP 2009284941
(71) Applicant: Fuji Electric Co., Ltd., Kawasaki-shi Kanagawa 210-9530 (JP)
(72) Inventor: WADA, Takenori, Kawasaki-shi Kanagawa 210-9530 (JP); YOSHIDA, Takashi, Kawasaki-shi Kanagawa 210-9530 (JP); YOKOYAMA, Shoji, Kawasaki-shi Kanagawa 210-9530 (JP); YAMADA, Takanori, Kawasaki-shi Kanagawa 210-9530 (JP); NISHIZAWA, Masanori, Kawasaki-shi Kanagawa 210-9530 (JP)
(74) Representative: Appelt, Christian W.
(86) International application number: PCT/JP2010/071868
(87) International publication number: WO 2011/074438

(57) **Abstract**

An apparatus 30 for control of the position of a flexible substrate 1 in the vertical width direction has first and second upper sandwiching roller pairs 31, 32, which can sandwich the upper edge of the flexible substrate while sending the flexible substrate; rotation shafts of the first upper sandwiching rollers 31 are inclined so as to have a deflection angle α directed obliquely upward with respect to a first transport direction F, in a sandwiching portion, of the flexible substrate, rotation shafts of the second upper sandwiching rollers 32 are inclined so as to have a deflection angle α directed obliquely upward with respect to a second transport direction R opposite the first transport direction in a sandwiching portion, and switching means for switching the first and second upper sandwiching roller pairs 31, 32 between operative/inoperative states is provided.

## Description

### TECHNICAL FIELD

The present invention relates to an apparatus for controlling the width-direction position of a flexible substrate in an apparatus that transports a strip-shaped flexible substrate and performs film deposition and other processing on the substrate in the transport path thereof.

### BACKGROUND ART

Normally a rigid substrate is used as the substrate of thin film stacked members of semiconductor thin films and similar, but there are cases in which plastic film or other flexible substrates are used, with the objects of improving productivity and reducing costs through lighter weight and the convenience of handling in roll form. Patent Reference 1 discloses an apparatus for manufacturing a thin film stacked member (thin film photoelectric conversion elements) in which a strip-shaped flexible substrate (polyimide film) supplied from an unwinding roller is transmitted intermittently at a prescribed pitch while forming stacked layers of a plurality of thin films with different properties on the flexible substrate in a plurality of film deposition units arranged along the direction of transport of the flexible substrate, and taking up the substrate as a finished product roll.

Among such apparatuses for the manufacture of thin film stacked members, there are an apparatus type employing a horizontal orientation, that is, which holds the strip-shaped flexible substrate in the width direction as a horizontal direction and transports the flexible substrate while performing film deposition, and an apparatus type employing a vertical orientation, that is, which holds the strip-shaped flexible substrate in the width direction as the vertical direction, and transports the flexible substrate while performing film deposition. The latter type has such advantages over the former type as smaller installation area and a decreased tendency for the substrate surface to be contaminated; but as in the case of providing a plurality of photoelectric conversion layers, as the number of film deposition chambers increases and as a result the transportation span lengthens, it will be difficult to maintain the position in the vertical width direction, that is, a constant transport height, in opposition to gravity, in use of only guide rollers on both sides of the film deposition portion. This causes a prominent tendency for wrinkle occurrences in the surface of the flexible substrate and for the flexible substrate to droop.

Hence it has been proposed that gripping roller pairs, which sandwich the upper edge in the vertical direction while feeding the flexible substrate, be provided between numerous film deposition units installed in a row (see Patent References 2 to 4). In such an apparatus, by inclining the rotation direction in the sandwiching portion of each of the gripping roller pairs upward with respect to the transport direction of the flexible substrate, a raising force can be imparted according to the flexible substrate sandwiching pressure and the inclination angle, and by controlling these parameters, the transport height of the flexible substrate can be maintained at a constant height.

Patent Reference 1: Japanese Patent Application Laid-open No. 2005-72408
Patent Reference 2: Japanese Patent Application Laid-open No. 2009-38276
Patent Reference 3: Japanese Patent Application Laid-open No. 2009-38277
Patent Reference 4: Japanese Patent Application Laid-open No. 2009-57632

Such an apparatus is useful for extending the flexible substrate in the vertical width direction and suppressing tension wrinkles and heat wrinkles, but cannot immediately be applied to a bidirectional film deposition process including transport of the flexible substrate in the reverse direction. If the flexible substrate is transported in the reverse direction, the raising forces and lowering forces which occur according to the above-described inclination angles (deflection angles) act in the opposite vertical directions, and not only are wrinkles and slack in the flexible substrate promoted, but the problem that the flexible substrate may separate from the sandwiching rollers arises.

### DISCLOSURE OF THE INVENTION

This invention was devised in light of the above problems, and has as an object the provision of an apparatus for flexible substrate position control which can suppress the occurrence of sagging of and wrinkles in a strip-shaped flexible substrate and which enables high-quality processing, and which in addition can also accommodate transport of the flexible substrate in the reverse direction.

In order to resolve the above problems, an apparatus for position control of a flexible substrate in a vertical direction in a processing apparatus that transports a strip-shaped flexible substrate in a vertical orientation and in a horizontal direction and that performs processing of the substrate on a path of the transport, has first and second upper sandwiching roller pairs which can send the flexible substrate while sandwiching an upper edge thereof; and the rotation shafts of the first upper sandwiching roller pair are each inclined such that the rotation direction in a sandwiching portion has a deflection angle directed obliquely upward with respect to a first transport direction of the flexible substrate, and rotation shafts of the second upper sandwiching roller pair are each inclined such that the rotation direction in a sandwiching portion has a deflection angle directed obliquely upward with respect to a second transport direction opposite the first transport direction, and the apparatus for position control of a flexible substrate further having:
a support mechanism, which rotatably supports each of the first and second upper sandwiching roller pairs, and which provides support such that one roller configuring each of the roller pair can be moved to be in contact with or apart from the other roller;
impelling means for imparting a clamping force to each of the roller pairs via the support mechanism; and
switching means for switching the first and second upper sandwiching roller pairs between operative/inoperative states by causing the second upper sandwiching roller pair to withdraw during the transport in the first transport direction and causing the first upper sandwiching roller pair to withdraw during the transport in the second transport direction.

In this invention, it is preferable that the impelling means has: first and second springs inserted in the support mechanism correspondingly to the first and second upper sandwiching roller pairs; and impelling force adjustment means for displacing support points of each of the springs so as to adjust the clamping forces of each of the upper sandwiching roller pairs.

In a preferred mode of this invention, the impelling force adjustment means has: a transmission mechanism which transmits the impelling forces of each of the springs to the support mechanism as torques; and a rotating member which induces angular displacement of the support points of each of the springs about the connection points with the transmission mechanism, and wherein the rotating member also serves as the switching means by including angular positions, at which the sandwiching roller pairs are caused to withdraw, as the angular displacements of the support points by the rotating member.

In another preferred mode of this invention, the switching means further has an operation member which can be alternately attached to and detached from the movable portion of the support mechanism corresponding to operation of contact/apart movement of the first and second upper sandwiching roller pairs, and through rotation or reciprocal motion of the operation member, the first and second upper sandwiching roller pairs are alternately caused to withdraw opposing to the impelling forces of the first and second springs.

In each of the above modes of this invention, the switching means may further have: an operation portion for an operator to use to manually operate the rotating member or operation member; and holding means for holding the rotating member or the operation member at each switching position. In this case, it is preferable that the switching means further comprise detection means for detecting that the rotating member or the operation member is held at each of the switching positions.

In this invention, it is preferable that first and second lower sandwiching roller pairs, which can send the flexible substrate while sandwiching the lower edge thereof, are further provided; that the first lower sandwiching roller pair is arranged at substantially the same position in the direction of transport of the flexible substrate as the first upper sandwiching roller, and rotation shafts are inclined such that the rotation direction in the sandwiching portion has a deflection angle inclined obliquely downward with respect to the first transport direction; that the second lower sandwiching roller pair is arranged at substantially the same position in the direction of transport of the flexible substrate as the second upper sandwiching rollers, and rotation shafts are inclined such that the rotation direction in the sandwiching portion has a deflection angle inclined obliquely downward with respect to the second transport direction, the invention further comprising:
a support mechanism which rotatably supports each of the first and second lower sandwiching roller pairs and which provides support such that one roller configuring each of the roller pair can be moved to be in contact with or apart from the other roller;
impelling means for imparting a clamping force to each of the roller pairs via the support mechanism; and
switching means for switching the first and second lower sandwiching roller pairs between operative/inoperative states by causing the second lower sandwiching roller pair to withdraw during the transport in the first transport direction and causing the first lower sandwiching roller pair to withdraw during the transport in the second transport direction.

An apparatus for flexible substrate position control of this invention can assume the following mode, including a horizontal orientation as well as a vertical orientation, when the first and second sandwiching roller pairs are arranged on each of the side edges of the flexible substrate. That is, an apparatus for position control in the width direction of a flexible substrate in a processing apparatus that transports the strip-shaped flexible substrate and performs processing of the substrate on a path of the transport has first and second sandwiching roller pairs on each side, which can send the flexible substrate while sandwiching the side edges in a width direction thereof; rotation shafts of the first sandwiching roller pairs on each side are inclined such that the rotation direction in each of sandwiching portions has a deflection angle directed outward from the width direction relative to a first transport direction of the flexible substrate; rotation shafts of the second sandwiching roller pairs on each side are inclined such that the rotation direction in each of sandwiching portions has a deflection angle directed outward from the width direction relative to a second transport direction of the flexible substrate opposite the first transport direction, the apparatus for flexible substrate position control further having:
a support mechanism, which rotatably supports each of the first and second sandwiching roller pairs on each side, and which provides support such that one roller configuring each of the roller pair can be moved to be in contact with or apart from the other roller;
impelling means for imparting a clamping force to each of the roller pairs via the support mechanism; and
switching means for switching the first and second sandwiching roller pairs on each side between operative/inoperative states by causing the second sandwiching roller pairs on each side to withdraw during the transport in the first transport direction and causing the first sandwiching roller pairs on each side to withdraw during the transport in the second transport direction.

As explained above, an apparatus for flexible substrate position control of this invention comprises, for the upper edge of a strip-shaped flexible substrate, a first upper sandwiching roller pair which causes a raising force to act during transport in a first transport direction, and a second upper sandwiching roller pair which causes a raising force to act during transport in a second transport direction opposite the first transport direction; and by further comprising switching means to cause one of these to withdraw to switch the first and second upper sandwiching roller pairs between operative/inoperative states, the direction of transport can be switched easily and promptly for transport in the first and second transport directions, that is, transport in forward and reverse directions, in a state in which the deflection angle and clamping force settings are maintained, for the first and second upper sandwiching roller pairs. Moreover, even during switching operation, the upper edge of the flexible substrate is always sandwiched by one of the upper sandwiching roller pairs, so that position shifting of the upper edge and similar during a switching operation does not occur, and the occurrence of drooping of and wrinkles in the flexible substrate can be suppressed continuously under the same conditions during transport in both forward and reverse directions, and moreover the position in the vertical width direction can be maintained at a constant position, and high-quality processing can be performed at low cost.

In a mode of this invention in which the impelling means comprises first and second springs corresponding to the first and second upper sandwiching roller pairs and interposed with the support mechanism, and impelling force adjustment means for displacing the support points of each of the springs so as to adjust the clamping forces of each of the upper sandwiching roller pairs, an apparatus for flexible substrate position control which can accommodate the above-described transport in forward and reverse directions can be configured inexpensively.

In a mode of this invention wherein the impelling force adjustment means comprises a transmission mechanism which transmits the impelling forces of each of the springs to the support mechanism as torques, and a rotating member which causes angular displacement of the support points of each of the springs about the connection points with the transmission mechanism, and wherein the rotating member also serves as the switching means by including angular positions at which the sandwiching roller pairs are caused to withdraw as the angular displacements of the support points by the rotating member, the angular components of the impelling forces contributing to the clamping forces of each of the sandwiching roller pairs, that is, the components orthogonal to the rotation radial direction of the spring connection points, can be gradually increased or decreased according to the angular displacements of the spring support points, so that high-precision control can be executed using a small driving force; in addition, merely by causing a spring support point to move to the withdrawal position of a sandwiching roller pair by the control action and a series of operations, the first or second upper sandwiching roller pair can be caused to withdraw and switching between operative/inoperative states can be performed, so that the apparatus can be simplified compared with a case in which the switching mechanism is constructed separately from the impelling force adjustment mechanism.

In a mode of this invention wherein the switching means comprises an operation member which can be alternately attached to and detached from the movable portion of the support mechanism corresponding to moving-together/apart operations of the first and second upper sandwiching roller pairs, and through rotation or reciprocal motion of the operation member, the first and second upper sandwiching roller pairs are alternately caused to withdraw in opposition to the impelling forces of the first and second springs, the first and second upper sandwiching roller pairs can be switched by a simple action of the single-system operation member common thereto corresponding to each of the forward and reverse transport directions, and so the mechanism of the switching means and the driving system can be simplified.

In a mode of this invention wherein the switching means further comprises an operation portion for a worker to manually operate the rotating member or operation member, and holding means to hold the rotating member or operation member at each of the switching positions, the switching means can be configured inexpensively. In particular, in an apparatus for performing film deposition on a strip-shaped flexible substrate by a roller process or similar, when the winding quantities of unwinding/takeup rollers are large, and the frequency of reversal of the forward/reverse transport direction is comparatively low, the cost entailed in additional introduction into an existing apparatus of an apparatus for flexible substrate position control which accommodates transport in both the forward and reverse directions can be reduced, which is advantageous.

In the above configuration, by further providing the switching means with detection means for detecting whether the rotating member or operation member is being held at each of the switching positions, erroneous operation due to manual operation errors during switching operations can be prevented.

In a mode of this invention wherein first and second lower sandwiching roller pairs, which can send the flexible substrate while sandwiching the lower edge, are further comprised; the first lower sandwiching roller pair is arranged at substantially the same position in the direction of transport of the flexible substrate as the first upper sandwiching rollers, and the rotation direction in the sandwiching portion has a deflection angle inclined obliquely downward with respect to the first transport direction; the second lower sandwiching roller pair is arranged at substantially the same position in the direction of transport of the flexible substrate as the second upper sandwiching rollers, and the rotation direction in the sandwiching portion has a deflection angle inclined obliquely downward with respect to the second transport direction; and further comprised are a support mechanism which rotatably supports each of the first and second lower sandwiching roller pairs and moreover provides support such that one roller comprised by each roller pair can be moved to be in contact with or apart from the other roller; impelling means, which imparts a clamping force to each of the roller pairs via the support mechanism; and switching means, which switches the first and second lower sandwiching roller pairs between operative/inoperative states by causing the second lower sandwiching roller pair to withdraw during transport in the first transport direction and causing the first lower sandwiching roller pair to withdraw during transport in the second transport direction, during transport in both the forward and reverse directions the strip-shaped flexible substrate is extended in the vertical direction, that is, the width direction, by means of the raising force due to the first or second upper sandwiching roller pair and the lowering force due to the first or second lower sandwiching roller pair, and moreover the transport direction can be changed while maintaining the extended state, so that the occurrence of drooping of and wrinkles in the flexible substrate can be suppressed still more effectively, which is advantageous for performing high-quality processing.

### BRIEF DESCRIPTION OF THE DRAWINGS

Fig. 1 shows a summary plane cross-sectional view (a) and a summary side cross-sectional view (b) of two film deposition units of a thin film stacked member manufacturing apparatus comprising an apparatus for flexible substrate position control of an embodiment of the invention;
Fig. 2 shows a summary plane view (a) and side view (b) of switching operation of a sandwiching roller pair in an apparatus for flexible substrate position control of an embodiment of the invention;
Fig. 3 is a summary plane view showing switching operation of a sandwiching roller pair in an apparatus for flexible substrate position control of another embodiment of the invention;
Fig. 4 is a side cross-sectional view of principal portions in Fig. 1(b) showing the apparatus for flexible substrate position control of the first embodiment of the invention;
Fig. 5 is a cross-sectional view along A-A in Fig. 4 with partial omission;
Fig. 6 is a plane view of principal portions showing the apparatus for flexible substrate position control of the first embodiment of the invention;
Fig. 7 shows a plane view of principal portions (a) and a side cross-sectional view of principal portions (b) of a modified example of the first embodiment of the invention;
Fig. 8 shows a side cross-sectional view of principal portions (a), a cross-sectional view along B-B therein (b), and a cross-sectional view along C-C therein (c), of the apparatus for flexible substrate position control of a second embodiment of the invention;
Fig. 9 shows a side cross-sectional view of principal portions (a), a cross-sectional view along B-B therein (b), and a cross-sectional view along C-C therein (c), of the apparatus for flexible substrate position control of a third embodiment of the invention; and
Fig. 10 shows a side cross-sectional view of principal portions (a) and a cross-sectional view along B-B therein (b) of the apparatus for flexible substrate position control of a fourth embodiment of the invention.

### BEST MODE FOR CARRYING OUT THE INVENTION

Below, embodiments of the invention are explained in detail referring to the drawings, taking as examples cases in which the invention is applied to apparatuses for flexible substrate position control in an apparatus for the manufacture of thin film stacked members comprising thin film photoelectric conversion elements for solar cells. In the following explanations, common or corresponding components in the embodiments are assigned common or corresponding symbols, and explanations thereof may be omitted.

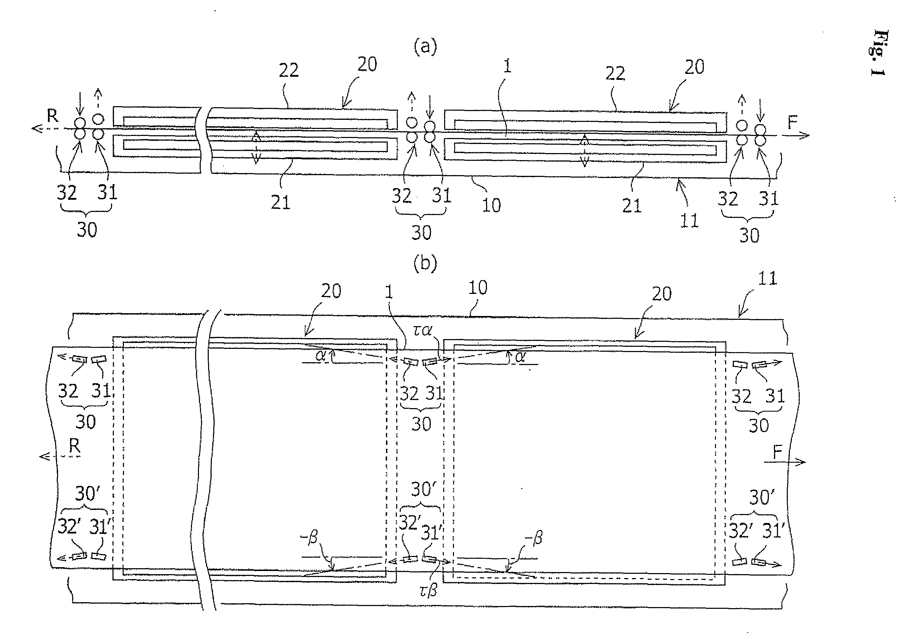

As shown in part in Fig. 1, in an apparatus for thin film stacked member manufacture 11, a transport path is formed within a common vacuum chamber 10 maintained at a prescribed vacuum to transport a strip-shaped flexible substrate 1 (plastic film) in a horizontal direction with the width direction thereof in the vertical direction, and a plurality of film deposition units 20 are installed in a row along the transport path. This thin film stacked member manufacturing apparatus 11 accommodates transport in both forward and reverse directions (first and second transport directions), as indicated by the symbols F and R in the figure, and although not shown in the figure, feed rollers, unwinding/takeup rollers, tension rollers, and similar are arranged in a row on both sides of the film deposition portion (20, 20, ...) corresponding to driving in both the forward and reverse directions via guide rollers (idle rollers) which guide the flexible substrate 1 across the entire width, from top to bottom.

Each of the film deposition units 20 is a vacuum evaporation deposition unit to perform chemical vapor deposition (CVD) such as plasma CVD or similar, or physical vapor deposition (PVD) such as sputtering or similar, and in essence are configured from an electrode 21 (a high-frequency electrode having numerous raw material gas emission holes on the surface, or a target) and a grounded electrode 22 incorporating a heater, sandwiching the flexible substrate 1 and arranged in opposition on both sides thereof. In a thin film stacked member manufacturing apparatus 11 which performs stepped film deposition processes, film deposition units 20 are arranged along the transport path of the flexible substrate 1 at an equal pitch, and the electrode 21 and grounded electrode 22 of each film deposition unit 20 are accommodated within a chamber opened toward the transport faces of the flexible substrate 1, and the electrode 21 and/or grounded substrate 22 are driven to advance or recede so as to open or close the chamber while step transport equivalent to one unit is stopped.

In each interval between the film deposition units 20 of the thin film stacked member manufacturing apparatus 11 having the basic configuration described above are provided position control apparatuses 30, 30' to maintain a constant transport height for the flexible substrate 1, and to extend the flexible substrate 1 in the width direction, that is, in the upward and downward directions. The position control apparatuses 30, 30' comprise an upper unit 30 installed in the upper portion of the transport path (1), and a lower unit 30' installed in the lower portion of the transport path (1).

The upper unit 30 comprises two sets of upper sandwiching roller pairs 31, 32 corresponding to first and second transport directions F, R, capable of transport while sandwiching the upper edge of the flexible substrate 1. Of these, the rotation direction in the portion sandwiching the flexible substrate 1 of the first upper sandwiching roller pair 31 corresponding to the first transport direction F has a deflection angle α directed obliquely upward with respect to the transport direction F, and the rotation direction in the portion sandwiching the flexible substrate 1 of the second upper sandwiching roller pair 32 corresponding to the second transport direction R has a deflection angle α directed obliquely upward with respect to the transport direction R. The respective deflection angles α are set to essentially the same angle.

The lower unit 30' is arranged at the same position in the transport directions F, R of the flexible substrate 1 as the upper unit 30, and comprises two sets of lower sandwiching rollers 31', 32', which are essentially the upper sandwiching rollers 31, 32 of the upper unit 30 arranged with vertical inversion. The rotation direction in the portion sandwiching the flexible substrate 1 of the first lower sandwiching roller pair 31' corresponding to the first transport direction F has a deflection angle β directed obliquely downward with respect to the transport direction F, and the rotation direction in the portion sandwiching the flexible substrate 1 of the second lower sandwiching roller pair 32' corresponding to the second transport direction R has a deflection angle β directed obliquely downward with respect to the transport direction R. The respective deflection angles P are set to essentially the same angle, and the absolute values of the upper and lower deflection angles α, β are also set to essentially the same value; but when a transport span is long or when in other cases drooping due to the weight of the flexible substrate 1 is considered, the deflection angle β of the lower unit 30' can be set to a value smaller than the deflection angle α of the upper unit 30.

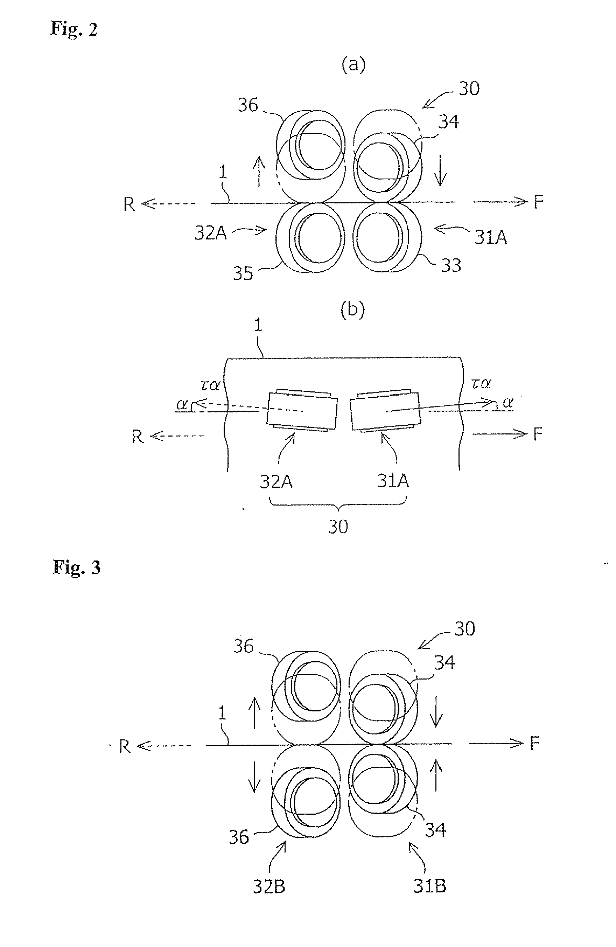

The first and second upper and lower sandwiching roller pairs 31, 32, 31', 32' comprised by the upper and lower units 30, 30' are each supported so as to enable rotation and also to enable moving together and apart by a support mechanism, described below, and configured such that the sandwiching roller pairs corresponding to either the first or second transport direction F or R are pressed together, in an operative state in which the upper and lower edges of the flexible substrate 1 are sandwiched, and the other sandwiching roller pairs are caused to move apart and put into an inoperative state. There exist two essential modes for the upper and lower units 30, 30', as shown in Fig. 2 and Fig. 3, according to operations to move the rollers comprised by each of the roller pairs 31, 32, 31', 32' together and apart. Each drawing shows only the upper unit 30, but operation is similar for the lower unit 30'.

In the first mode shown in Fig. 2, one of the rollers comprised by each of the roller pairs 31A, 32A is a fixed roller 33, 35, and the other rollers are movable rollers 34, 36; during transport of the flexible substrate 1 in the first transport direction F, the movable roller 34 of the first upper sandwiching roller pair 31A is pressed to be in contact with the fixed roller 33, and the movable roller 36 of the second upper sandwiching roller pair 32A is moved away from the fixed roller 35, as shown by the solid lines in Fig. 2(a); by this means, a raising force τα directed obliquely upward according to a deflection angle α with respect to the first transport direction F acts on the upper edge of the flexible substrate 1, as shown in Fig. 2(b).

On the other hand, during transport of the flexible substrate 1 in the second transport direction R, the movable roller 36 of the second upper sandwiching roller pair 32A is pressed to be in contact with the fixed roller 35, and the movable roller 34 of the first upper sandwiching roller pair 31A is withdrawn from the fixed roller 33, as shown by the double-dash lines in Fig. 2(a), so that a raising force τα acts on the upper edge of the flexible substrate 1 directed obliquely upward according to the deflection angle α relative to the second transport direction R, as shown by the dashed line in Fig. 2(b).

In a second mode shown in Fig. 3, the rollers comprised by each of the roller pairs 31B, 32B are all movable rollers 34, 34, 36, 36, and during transport of the flexible substrate 1 in the first transport direction F, the movable rollers 34, 34 of the first upper sandwiching roller pair 31B are pressed together and the movable rollers 36, 36 of the second upper sandwiching roller pair 32B are moved apart, as shown by the solid lines in Fig. 3; by this means, a raising force τα acts on the upper edge of the flexible substrate 1 directed obliquely upward with respect to the first transport direction F.

On the other hand, during transport of the flexible substrate 1 in the second transport direction R, the movable rollers 36, 36 of the second upper sandwiching roller pair 32B are pressed together and the movable rollers 34, 34 of the first upper sandwiching roller pair 31B are moved apart, as shown by the double-dash lines in Fig. 3; by this means, a raising force τα acts on the upper edge of the flexible substrate 1 directed obliquely upward with respect to the second transport direction R.

In either mode, the switching operation to switch the first and second upper sandwiching roller pairs 31A, 32A, 31B, 32B between operative/inoperative states is performed in a halted state when the transport direction F, R of the flexible substrate 1 is changed. At this time, by first pressing together the other set of upper sandwiching roller pairs (for example 32A, 32B) and then moving apart the one set of upper sandwiching roller pairs (31A, 31B), the state of sandwiching the flexible substrate 1 is handed over from one set of upper sandwiching roller pairs (31A, 31B) to the other set of upper sandwiching roller pairs (for example 32A, 32B), and by this means, shifts in the position of the flexible substrate 1 during switching operations of the first and second upper sandwiching roller pairs 31A, 32A, 31B, 32B can be prevented.

Next, embodiments of apparatuses for flexible substrate position control based on the above two basic modes are explained in detail, referring to the drawings.

### (First Embodiment)

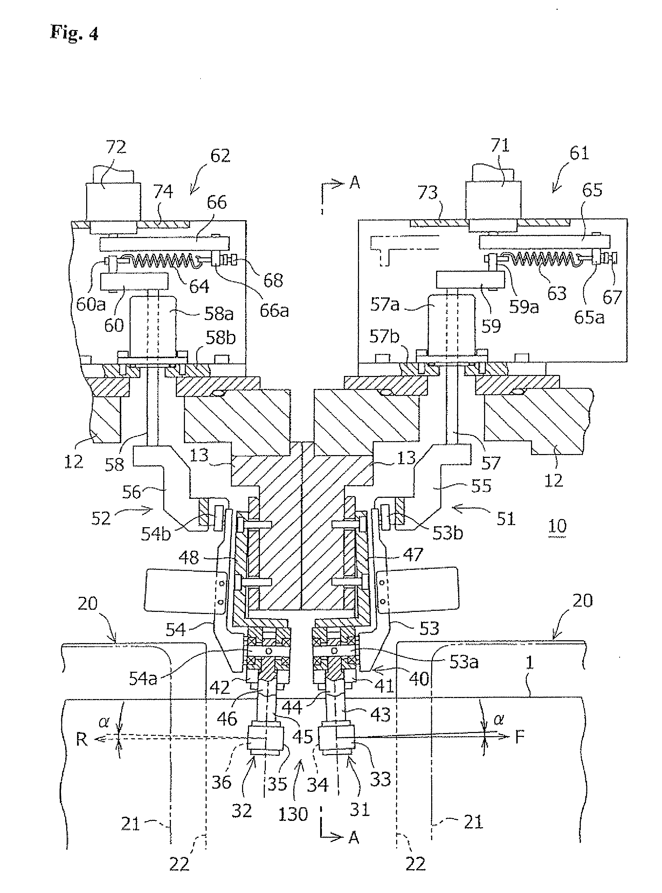

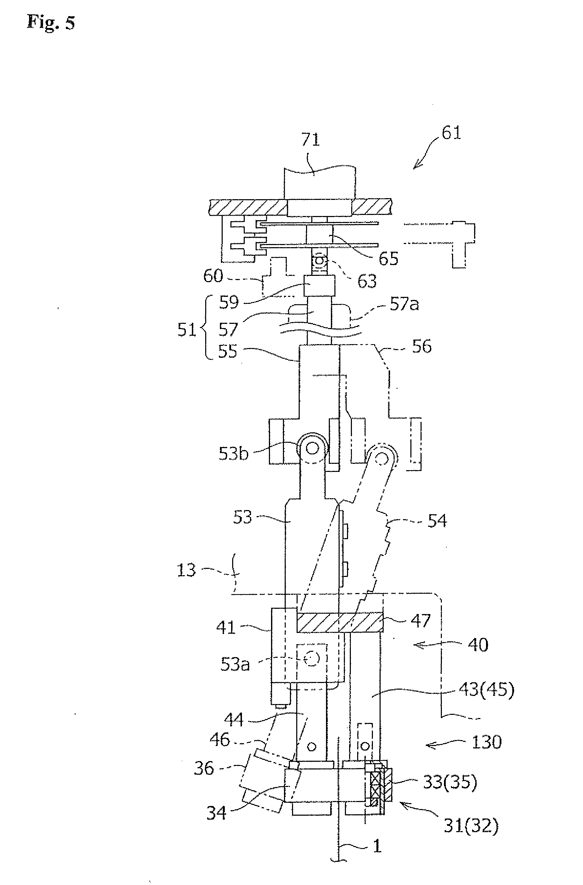

Fig. 4 to Fig. 6 show the position control apparatus 130 of a first embodiment of the invention. The first and second upper sandwiching roller pairs 31, 32 of the position control apparatus 130 comprise fixed rollers 33, 35 and movable rollers 34, 36, supported by a support mechanism 40 so as to enable movement together and apart. As shown in Fig. 5, each of the fixed rollers 33, 35 is rotatably supported via bearings by a support shaft provided on an end (the lower end) of a fixed support member 43, 45, and comprises a metal roller body, and a heat-resistant rubber covering portion covering the peripheral face thereof. As the bearings, ball bearings which can receive the shaft-direction load, angular-contact ball bearings, or similar are used. Each of the mobile rollers 34, 36 is also rotatably supported in a similar manner by a movable support member 44, 46.

Each of the fixed support members 43, 45 is fixed, at the base end (upper end) thereof, to the lower face of a bracket 47, 48 comprising deflection angle adjustment means. Each of the brackets 47, 48 is fixed, via a shim, to a fixing plate of a main structure 13 of a chamber structure unit, divided into individual film deposition units 20; the mounting angle of each of the brackets 47, 48 can be modified according to the shim thickness and/or the number of shims, and by this means, the deflection angle α of the fixed rollers 33, 35 and movable rollers 34, 36 comprised by each of the sandwiching roller pairs 31, 32 can be adjusted.

The movable support members 44, 46 are respectively fixed to shaft portions 53a, 54a of extended arms 53, 54 at the base end (upper end). Each of the shaft portions 53a, 54a is rotatably supported via bearings by support portions 41, 42 respectively fastened to the lower face of the brackets 47, 48, and each of the movable support members 44, 46 can rotate integrally with the extended arms 53, 54 about the shaft portions 53a, 54a; by this means, each of the movable rollers 34, 36 can separately move to be in contact with or apart from the fixed rollers 33, 35.

On the upper ends of the extended arms 53, 54 are rotatably mounted rollers 53b, 54b engaged with the tip ends of crank arms 55, 56. Each of the crank arms 55, 56 (output arms) is fixed to the lower end of a respective rotating shaft 57, 58, which together with crank arms 59, 60 (input arms) fixed to the upper ends of the rotating shafts 57, 58 penetrating to outside the vacuum chamber 10, form impelling force transmission mechanisms 51, 52.

Each of the rotating shafts 57, 58 is rotatably supported, in a state in which a pressure difference between the inside and outside of the vacuum chamber is maintained, by sealed bearings 57a, 58a hermitically mounted in a ceiling panel 12 of the vacuum chamber 10 (chamber structure unit) via baseplates 57b, 58b and O-rings. Springs 63, 64 are connected at one end to the tip ends 59a, 60a of the crank arms 59, 60 positioned outside the vacuum chamber 10, and the other ends of the springs 63, 64 are connected, via respective adjustment screws 67, 68, to the tip ends 65a, 66a of driving arms 65, 66 (rotating members) forming impelling force adjustment means 61, 62. The tip ends 59a, 60a and 65a, 66a are each rotatably supported by the crank arms 55, 56 and driving arms 65, 66 via bearings, not shown.

The springs 63, 64 are stretched, in a state of extension in advance, between the tip ends 59a, 60a of the crank arms 59, 60 and the tip ends 65a, 66a of the driving arms 65, 66; by adjusting the degree of extension using the adjustment screws 67, 68, the tension of the springs 63, 64 can be adjusted. As stated below, the maximum value of the impelling force imparting a clamping force to each of the sandwiching roller pairs 31, 32 is determined according to this tension.

The driving arms 65, 66 are fixed at the base ends to the driving shafts of actuators 71, 72. The actuators 71, 72 are servomotors incorporating encoders or other rotary actuators, and are mounted on upper plates 73, 74 fixed via a supporting frame, not shown, above the baseplates 57b, 58b such that the driving shafts thereof are opposed to, and the shaft centers made to coincide with, the tip ends 59a, 60a of the crank arms 59, 60 in action positions (more precisely, the rotation origins of the crank arms 59, 60 corresponding to cases in which the movable rollers 34, 36 abut the fixed rollers 33, 35 with zero contact force).

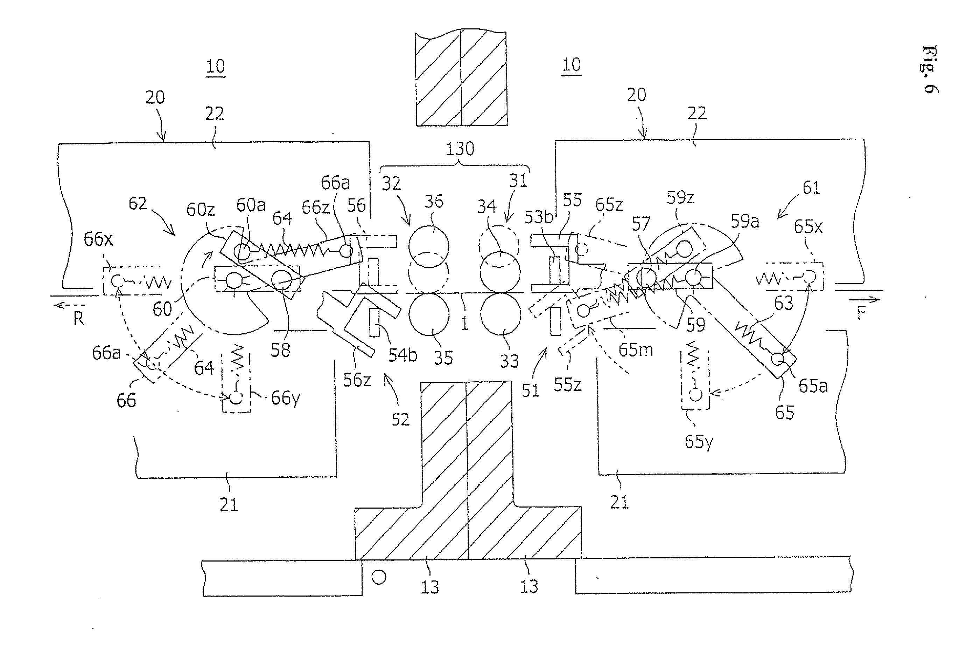

The actuators 71, 72 are driven by control signals from a control portion, not shown, and are configured so as to form switching means to perform switching between the following three positions by rotationally displacing the driving arms 65, 66 as shown in Fig. 6. That is, by means of the actuators 71, 72, switching can be performed between:
(a) operative positions (65x to 65y, 66x to 66y) such that the driving arms 65, 66 are rotationally displaced to between minimum pressing positions 65x, 66x (rotation origin) and maximum pressing positions 65y, 66y, and an impelling force according to this angular displacement is applied to the sandwiching roller pairs 31, 32 via the crank arms 59, 60;
(b) inoperative positions (65z, 66z) such that the crank arms 59, 60 (55, 56) are forcibly reversed and the movable rollers 34, 36 of the sandwiching roller pairs 31, 32 are withdrawn from the fixed rollers 33, 35, as indicated by 59z, 60z (55z, 56z) in the figure; and
(c) toggle positions (65m), shown only for the right-side sandwiching roller pair 31 in the figure, such that the crank arms 59, 60 are in a bistable state which can be held at both pressing positions (59, 60) and at reversed positions (59z, 60z).

Fig. 4 to Fig. 6 show cases in which the first sandwiching roller pair 31, corresponding to the first transport direction F, is in the operative position, and the movable roller 34 thereof is pressed against the fixed roller 33, whereas the second sandwiching roller pair 32, corresponding to the second transport direction R, is in the inoperative position, and the movable roller 36 thereof is withdrawn from the fixed roller 35.

That is, in Fig. 6, when the driving arm 65 corresponding to the first sandwiching roller pair 31 is arranged in a straight line with the crank arm 59 in the operative position, in the position of minimum pressing 65x with zero angular displacement, the tension of the spring 63 does not include an orthogonal component causing rotation of the crank arm 59 from this position in the clockwise direction in Fig. 6, and an impelling force does not occur. At this minimum pressing position 65x, the tension of the spring 63 acts mainly as a component to hold the crank arm 59 at the rotation origin.

When the driving arm 65 is rotated from this state, according to this angular displacement, the orthogonal component of the tension of the spring 63 acts as an impelling force to rotate the crank arm 59 in the clockwise direction in Fig. 6. This impelling force is transmitted via the crank arm 55 which is integral with the rotation shaft 57 and the roller 53b engaged with the crank arm 55 to the extended arm 53, and the movable roller 34 is pressed against the fixed roller 33 by a pressing force resulting from the product of the impelling force with the lever ratio.

Further, when the driving arm 65 is rotated to the maximum pressing position 65y orthogonal to the crank arm 59 at the operative position, the entire tension of the spring 63 acts as an impelling force to rotate the crank arm 59 in the clockwise direction in the figure, and the movable roller 34 is pressed against the fixed roller 33 with the maximum pressing force resulting from the product of the tension of the spring 63 with the lever ratio.

In this way, when the first sandwiching roller pair 31 is at the operative position, an impelling force according to the angular displacement of the driving arm 65 is applied to the movable roller 34 via the crank arm 59, and as shown in Fig. 4, the upper edge of the flexible substrate 1 is sandwiched while being transported by the movable roller 34 and fixed roller 33 having a deflection angle α directed obliquely upward, so that a raising force is imparted to the upper edge of the flexible substrate 1 according to the sandwiching force.

On the other hand, the driving arm 66 corresponding to the second sandwiching roller pair 32 is in the inoperative position 66z rotationally displaced over 180° in the counterclockwise direction from the rotation origin (66x), and the crank arm 60 is held in the reversed position 60z by the impelling force of the spring 64. Accompanying this, by rotationally displacing the crank arm 56, which is integral with the crank arm 60 via the rotation shaft 58, in the clockwise direction in Fig. 6, inclining the extended arm 54 as shown by the double-dash lines in Fig. 5, the movable roller 36 is caused to withdraw from the fixed roller 35.

Next, when after film deposition processes performed by transporting the flexible substrate 1 in the first transport direction F are completed, the transport direction is reversed, and a transition is made to film deposition processes performed by transporting in the second transport direction R, the following procedure is used to perform the reversal operation.

First, transport of the flexible substrate 1 in the first transport direction F is halted, and in the state in which the upper edge of the flexible substrate 1 is sandwiched by the first sandwiching roller pair 31, the actuator 72 is activated, and the driving arm 66 corresponding to the second sandwiching roller pair 32 is rotated in the clockwise direction in Fig. 6, and is moved to the activation position equivalent to the angular displacement of the driving arm 65 corresponding to the first sandwiching roller pair 31 while halted. By this means, the movable roller 36 of the second sandwiching roller pair 32 is pressed against the fixed roller 35 with a pressing force equal to that of the movable roller 34 of the first sandwiching roller pair 31, and the upper edge of the flexible substrate 1 is sandwiched by both the first and second sandwiching roller pairs 31 and 32.

Then, the driving arm 65 corresponding to the first sandwiching roller pair 31 is rotated to the inoperative position 65z, and the movable roller 34 of the first sandwiching roller pair 31 is caused to withdraw from the fixed roller 33, and by this means, in a state in which the transport height of the flexible substrate 1 is maintained, transition to film deposition processes employing transport in the second transport direction R is made possible.

Further, when the flexible substrate 1 is initially introduced into the thin film stacked member manufacturing apparatus 11, the actuator 71 is activated, the driving arm 65 is rotated to the inoperative position 65z, the movable roller 34 of the sandwiching roller pair 31 is withdrawn from the fixed roller 33, and thereafter the driving arm 65 is rotationally displaced to the toggle position 65m. In this state, the support point (65a) of the spring 63 is on the inoperative position side of the straight line connecting the connection point (59z) with the crank arm 59 and the rotation shaft 57, and by means of the impelling force of the spring 63, the sandwiching roller pair 31 is held at the inoperative position, the movable roller 34 remains withdrawn from the fixed roller 33, and a standby angle is left with respect to the dead point of the toggle mechanism.

Next, after introducing the flexible substrate 1 between the electrode 21 and the grounded electrode 22 of each film deposition unit 20, a worker presses and makes upright the extended arm 53 of the sandwiching roller pair 31 in opposition to the impelling force of the spring 63, upon which the crank arm 55 and the crank arm 59 which is integral with the crank arm 55 via the rotation shaft 57 rotates to the operative position indicated by the clockwise-direction solid line in Fig. 6. Through this operation, the connection point (59a) of the spring 63 exceeds the dead point of the toggle mechanism, and by means of the impelling force of the spring 63 the movable roller 34 is immediately pressed against the fixed roller 33, and the introduced flexible substrate 1 is sandwiched by the sandwiching roller pair 31.

As already shown in Fig. 1, in the thin film stacked member manufacturing apparatus 11, position control apparatuses 30 including first and second sandwiching roller pairs 31, 32 are arranged in each of the intervals between film deposition units 20 along the transport path of the flexible substrate 1; but it is not necessary that all the position control apparatuses 30 be capable of active control of the sandwiching force of the sandwiching roller pairs 31, 32 as described above. For example, only the upper position control apparatus 30 (130) positioned substantially in the center of the transport span in the film deposition portion may be made capable of active control, while other upper and lower position control apparatuses 30, 30' can be made preset-type apparatuses, the sandwiching forces of the sandwiching roller pairs 31, 32 of which, that is, the spring impelling forces of which, are adjusted in advance to the optimum values.

### (Modified Example of the First Embodiment)

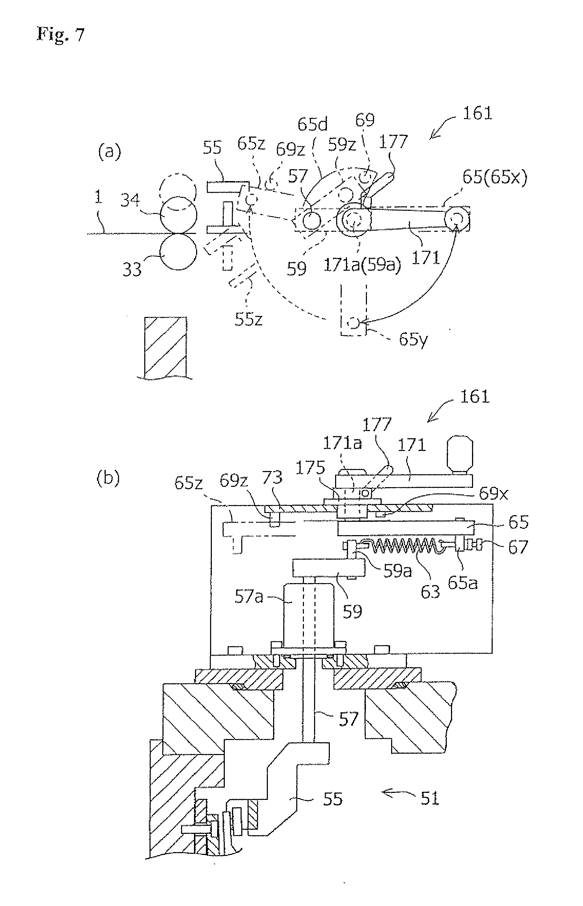

Fig. 7 shows preset-type impelling force adjustment means 161, with the actuator 71 in the impelling force adjustment means 61 of the active position control apparatus 130 replaced with a handle 171 for manual operation, as a modified example of the above-described first embodiment.

This impelling force adjustment means 161 has the driving arm 65 mounted on the rotation shaft 171a of the handle 171 rotatably supported by bearings 175, so that the handle 171 can be used for rotation operation of the driving arm 65; in addition, by providing a clamp 177 which can fix the rotation shaft 171a of the handle 171 at an arbitrary angular position, the impelling force of the spring 63 (64) can be adjusted in advance by a simple operation.

Further, by operation of the handle 171 the driving arm 65 is rotated to the inoperative position 65z and the movable roller 34 is withdrawn from the fixed roller 33, putting the first sandwiching roller pair (31) into the inoperative state, and putting the second sandwiching roller pair (32) into the operative state, so that transition to film deposition processes employing transport in the second transport direction R is possible. In the above inoperative state, the movable roller 34 withdrawn from the fixed roller 33 is held in the withdrawn position by the impelling force of the spring 63 (64), as stated above; but the handle 171 may be fixed in this position by the clamp 177 as well.

Further, a sector plate 65d is mounted concentrically on the base of the driving arm 65, and a sensor 69 which detects the driving arm 65 in the operative state (65x to 65y) is provided on the lower face of the upper plate 73 in proximity to the outer periphery of the sector plate 65d; on the other side of the lower face of the upper plate 73 is provided a sensor 69z which detects the driving arm 65 in the inoperative position 65z. By providing these sensors 69, 69x in an interlock system coordinated with the transport directions F, R of the thin film stacked member manufacturing apparatus 11, erroneous operations when a worker manually performs switching operations can be prevented.

### (Second Embodiment)

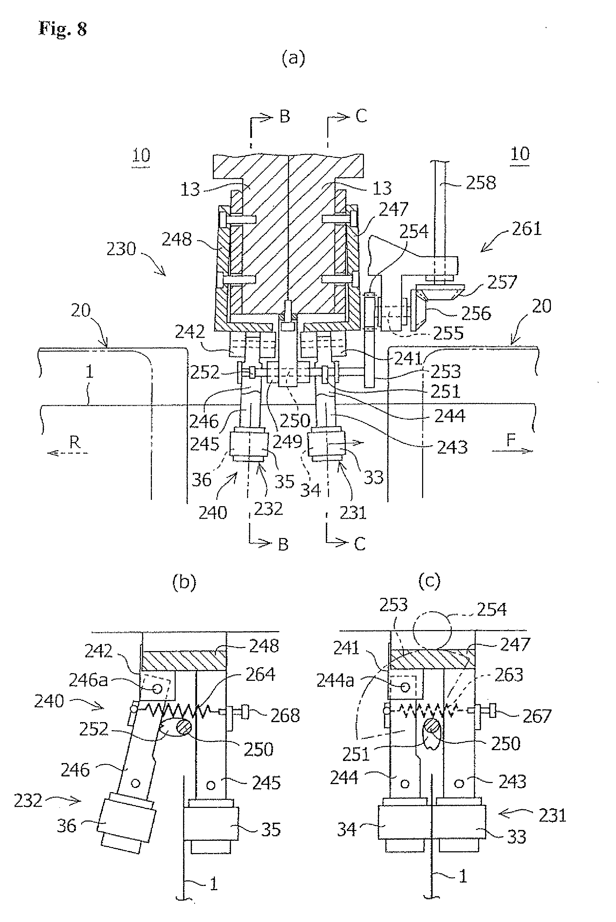

Figs. 8(a) to 8(c) show the position control apparatus 230 of a second embodiment of the invention. In this position control apparatus 230 also, similarly to the first embodiment, first and second upper sandwiching roller pairs 231, 232 comprise fixed rollers 33, 35 and movable rollers 34, 36, supported by a support mechanism 240 so as to enable moving together and apart. The movable support members 244, 246 of the movable rollers 34, 36 are rotatably supported at the base ends (upper ends), via rotation shafts 244a, 246a, by support portions 241, 242 fixed to the lower faces of brackets 247, 248.

Springs 263, 264 are stretched between the movable support members 244, 246 and the corresponding fixed support members 243, 245, and the movable rollers 34, 36 are pressed against the corresponding fixed rollers 33, 35 by the impelling of these springs 263, 264. This position control apparatus 230 is a preset type in which the impelling forces of the springs 263, 264 are adjusted in advance by adjustment screws 267, 268; separately from these impelling force adjustment means, a switching apparatus 261 which switches the first and second upper sandwiching roller pairs 231, 232 between operative/inoperative states is also provided.

The switching apparatus 261 comprises a driving mechanism including first and second cams 251, 252 which can be engaged with and disengaged from the movable support members 244, 246 of the first and second upper sandwiching roller pairs 231, 232, and a camshaft 250 common thereto. The camshaft 250 extends parallel to the transport directions F, R of the flexible substrate 1 through the interval between the fixed support members 243, 245 and the movable support members 244, 246 of the first and second upper sandwiching roller pairs 231, 232 respectively, and midway between the first and second cams 251, 252, a bracket 249, fixed to the lower ends of the main structures 13, 13, is rotatably supported.

The first and second cams 251, 252 are either fixed to or are integral with the camshaft 250, with phase shifted 90°; as shown in Figs. 8(b) and 8(c), two vertices are provided, surrounding a groove, in each of the tip ends thereof, such that a stable engaged state with the movable support members 244, 246 can be obtained. On the end of the camshaft 250 on the side of the first upper sandwiching roller pair 231 is fixed a sector gear 253. This sector gear 253 meshes with a pinion gear 254 fixed at one end of an intermediate shaft 255, and the other end of the intermediate shaft 255 is configured such that the rotation of an actuator (not shown), provided outside the vacuum chamber 10, is transmitted via a pair of bevel gears 256, 257 and a rotation shaft 258.

By means of the above configuration, during transport in the first transport direction F, the first cam 251 is detached from the movable support member 244 and the movable roller 34 of the first upper sandwiching roller pair 231 is pressed against the fixed roller 33 to enter the operative state, as shown in Fig. 8(c), whereas the second cam 252 is engaged with the movable support member 246 and the movable roller 36 of the second upper sandwiching roller pair 232 is withdrawn from the fixed roller 35 to enter the inoperative state, as shown in Fig. 8(b), and by means of the first upper sandwiching roller pair 231 a prescribed raising force, according to the deflection angle α and pressing force thereof, is imparted to the upper edge of the flexible substrate 1 which is transported in the transport direction F.

Next, when film deposition processes employing transport in the first transport direction F are completed, and a transition is made to film deposition processes employing transport in the second transport direction R, a switching operation is performed to rotate the camshaft 250, via the driving mechanism (253 to 258), 90° in the clockwise direction in the figure from the state shown in Figs. 8(b) and 8(c). By this means, the first cam 251 engages with the movable support member 244, the movable roller 34 of the first upper sandwiching roller pair 231 is withdrawn from the fixed roller 33 to enter the inoperative state, and on the other hand the second cam 252 is disengaged upward from the movable support member 246, the movable roller 36 of the second upper sandwiching roller pair 232 is pressed against the fixed roller 35 and the operative state is entered, and by means of the second upper sandwiching roller pair 232 a prescribed raising force according to the deflection angle α and pressing force thereof is imparted to the upper edge of the flexible substrate 1 which is transported in the transport direction R.

In the switching apparatus 261 of the above second embodiment, switching is performed merely by moving the camshaft 250 back and forth between two positions over a prescribed angular interval (90° in the example shown), and so a configuration can also be employed in which a handle (lever) is mounted on the rotation shaft 258 as in the above-described modified example of the first embodiment, to enable operations to switch the transport direction by a manual operation outside the vacuum chamber 10. In this case, as described above, an interlock system for the driving system of the manufacturing apparatus 11 should be equipped, providing a holding mechanism to hold the handle (lever) in each of the rotation positions corresponding to the operative/inoperative states and sensors to detect the holding states. Further, again as described above, it is preferable that a configuration be employed wherein, depending on the shapes of the cams 251 and 252, the roller pair which had been in the operative state is withdrawn after completion of sandwiching by the roller pair which had been in the inoperative state.

### (Third Embodiment)

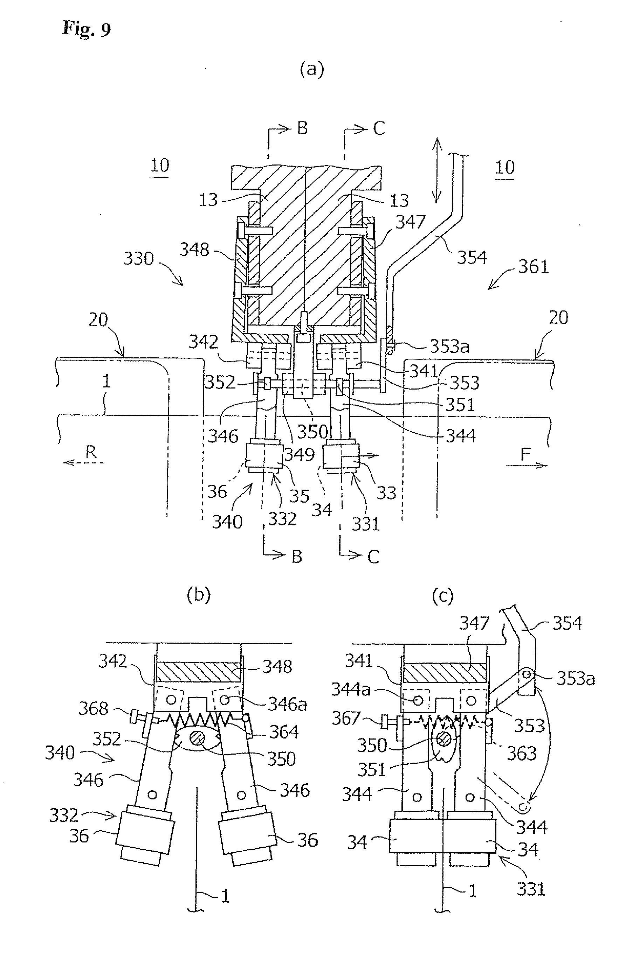

Figs. 9(a) to 9(c) show the position control apparatus 330 of a third embodiment of the invention. This position control apparatus 330 is equivalent to the second basic mode shown in Fig. 3; the first and second upper sandwiching roller pairs 331, 332 comprise respective pairs of movable rollers 34, 34 and 36, 36, supported so as to enable mutual moving together and apart by a support mechanism 340, and the movable support members 344, 344 and 346, 346 are rotatably supported at the base ends (upper ends) thereof, via rotation shafts 344a, 346a, by support portions 341, 342 fixed to the lower faces of the brackets 347, 348; springs 363, 364 are stretched via adjustment screws 367, 368 between the respective movable support members 344, 344 and 346, 346.

In the switching apparatus 361 of the position control apparatus 330 of this third embodiment also, similarly to the above, first and second cams 351, 352 and a camshaft 350 common thereto are provided; but the two cams 351, 352 differ in that each has two cam noses at 180° intervals, such that simultaneous engagement with both the movable support members 344, 344 and 346, 346 is possible. Further, in place of a gear at the end of the camshaft 350, a lever 353 is fixed, and the lower end of an operation rod 354 is rotatably connected via a shaft 353a to the tip end of the lever 353; by moving this operation rod 354 up and down, switching of the first and second upper sandwiching roller pairs 331, 332 between operative/inoperative states is possible. The operation rod 354 is similar to the each of the above embodiments in that operation is possible using an actuator or a handle (lever) for manual operation arranged outside the vacuum chamber 10, and in that a holding mechanism and sensors can be provided at each of the vertical-direction positions to configure an interlock system to prevent erroneous operations.

### (Fourth Embodiment)

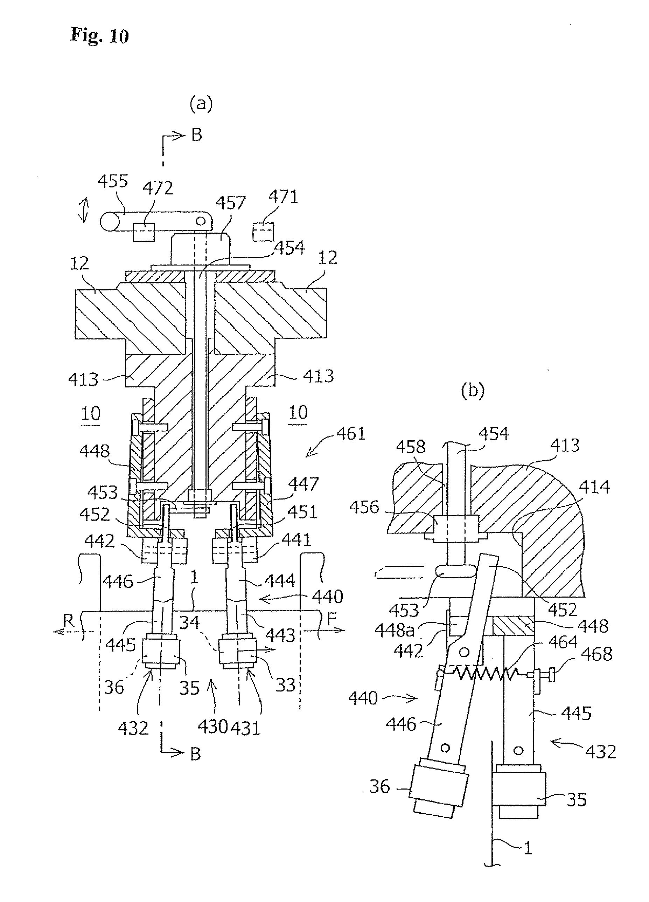

Figs. 10(a) and 10(b) show the position control apparatus 430 of a fourth embodiment of the invention. In this position control apparatus 430, similarly to the above-described second embodiment, first and second upper sandwiching roller pairs 431, 432 comprise fixed rollers 33, 35 and movable rollers 34, 36 supported by a support mechanism 440 so as to enable moving together and apart; the movable support members 444, 446 are rotatably supported at the base ends (upper ends) by support portions 441, 442, and springs 463, 464 are stretched, via adjustment screws (467) 468, between the movable support members 444, 446 and the corresponding fixed support members 443 (445).

In this position control apparatus 430, the movable support members 444, 446 have extended portions 451, 452 extending upward past the rotation support points thereof. The upper ends of the extended portions 451, 452 extend upward passing through cutout portions (447a) 448a in the brackets 447, 448, to reach the interior of a recess 414 delimited by the bottom faces of the main structures 413, 414. In this recess 414, a penetrating hole 458 which penetrates to outside the vacuum chamber 10 along the joined portions of the main structures 413, 413 is opened, and a rotation shaft 454 comprised by the switching apparatus 461 is passed through this penetrating hole 458.

The rotation shaft 454 is rotatably supported by bearings 456 provided in the penetrating hole 458 and sealed bearings 457, and an operation arm 453 which can be engaged and disengaged selectively with the upper end of the extended portions 451, 452, according to rotation operation in both directions of the rotation shaft 454, is fixed to the lower end of the rotation shaft 454 positioned in the recess 414. A handle 455 to perform rotational operation of the rotation shaft 454 is rotatably connected to the upper end of the rotation shaft 454 positioned outside the vacuum chamber 10. Further, at both ends of the rotation range of the handle 455 are arranged holding members 471, 472 which lock the handle 455 at the respective positions.

In the position control apparatus 430 of the fourth embodiment, when executing film deposition processes employing transport in the first transport direction F, by operating the handle 455 the rotation shaft 454 is rotated to the left side in the figure, and in this position the handle 455 is locked by the holding member 472. In this position, as shown in Figs. 10(a) and 10(b), the operation arm 453 is engaged with the extended portion 452 of the movable support member 446 in the second upper sandwiching roller pair 432, and by pressing the extended portion 452, the movable roller 36 is withdrawn from the fixed roller 35, the second upper sandwiching roller pair 432 enters the inoperative state, and by means of the first upper sandwiching roller pair 431 which is in the operative state, a prescribed raising force according to the deflection angle α and pressing force thereof can be imparted to the upper edge of the flexible substrate 1 which is transported in the transport direction F.

When film deposition processes employing transport in the first transport direction F are completed, and a transition is made to film deposition processes employing transport in the second transport direction R, the handle 455 is lifted and a rotation operation in the right direction in the figure is performed, to first cause the operation arm 453 to be disengaged from the extended portion 452, the movable roller 36 of the second upper sandwiching roller pair 432 is pressed against the fixed roller 35, and a state is entered in which the upper edge of the flexible roller 1 is sandwiched by both the first and second upper sandwiching roller pairs 431, 432.

Next, by further rotation of the rotation shaft 454 by the handle 455, the operation arm 453 engages with the extended portion 451 of the movable support member 444 in the first upper sandwiching roller pair 431, and by pressing the extended portion 451, the movable roller 34 is withdrawn from the fixed roller 33, the first upper sandwiching roller pair 431 enters the inoperative state, and by means of the second upper sandwiching roller pair 432 which is already in the operative state, a prescribed raising force according to the deflection angle α and pressing force thereof can be imparted to the upper edge of the flexible substrate 1 which is transported in the transport direction R.

Sensors can be mounted at each of the holding members 471, 472 to detect that the handle 455 is being held at those positions, to provide an interlock system for prevention of erroneous operation accommodating the transport directions F, R of the thin film stacked member manufacturing apparatus 11. In the position control apparatus 430 of the fourth embodiment also, similarly to each of the above embodiments, the rotation shaft 454 can be driven by an actuator.

Further, if the position control apparatuses 430 in the interval between film deposition units 20 are interconnected by a linking mechanism, simultaneous switching of a plurality of position control apparatuses 430 can be performed by operating a single handle 455. Further, if the rotation shafts 454 of upper and lower position control apparatuses 430 are connected or used in common, both the upper and lower position control apparatuses 430 can be switched simultaneously by operating the upper handle 455. This is similar to the case of driving the rotation shafts 454 using an actuator.

In the above, embodiments of the invention have been described; but the invention is not limited to the above embodiments, and various further modifications and alterations other than the above are possible based on the technical concept of this invention.

For example, in each of the above embodiments, cases were presented in which coil springs were used as impelling means (springs); but spiral springs, leaf springs, or other well-known spring types can be used, and moreover installation is possible either within or outside of the vacuum chamber 10.

Further, in the above embodiments, cases were presented in which position control apparatuses 30, 30' were installed on the upper and lower sides in the intervals between adjacent units of numerous film deposition units 20 installed in a row along the transport path of the flexible substrate 1, one upper unit 30 substantially in the center could be controlled, and the other units were of the preset type; but a configuration can be employed in which a plurality of upper units 30 can be controlled, either simultaneously or individually.

Further, in cases where the length in the transport direction of film deposition units 20 is comparatively short or similar, position control apparatuses 30, 30' can be installed at every one to two units, and in cases where the number of film deposition units 20 is small (for example, two) and transport spans are comparatively short, the position control apparatus can comprise only upper units 30 which can be controlled. In the latter case, by balancing the weight acting on the flexible substrate 1 and the raising force of the upper units 30, control is performed to maintain the transport level of the flexible substrate at a constant height.

Further, in the above embodiments, cases were explained in which the position control apparatus of the invention is implemented in a thin film stacked member manufacturing apparatus in which a flexible substrate is transported in steps while performing film deposition processes; but a position control apparatus of this invention can also be implemented in a continuous film deposition-type thin film stacked member manufacturing apparatus in which the flexible substrate is transported continuously while performing film deposition.

Further, in addition to apparatuses for the manufacture of thin film stacked members for solar cells, a flexible substrate position control apparatus of this invention can be applied as position control apparatuses for, in addition to apparatuses for the manufacture of organic EL and other semiconductor thin films, various processes apparatuses for flexible substrates entailing other than film deposition, such as application, cleaning, drying, heat treatment, surface fabrication, and similar. Further, a flexible substrate position control apparatus of this invention can be implemented in cases where the flexible substrate is transported with a vertical orientation (or an inclined orientation) in a horizontal direction (including oblique directions), and in cases where the flexible substrate is transported in a horizontal direction, vertical direction, or oblique direction with a horizontal orientation.

### EXPLANATION OF REFERENCE NUMERALS

- 1: Flexible substrate
- 10: Vacuum chamber
- 11: Thin film stacked member manufacturing apparatus
- 13 Main: structure
- 20 Film: deposition unit
- 30, 130, 230, 330, 430: Position control apparatus (upper unit)
- 30' Position: control apparatus (lower unit)
- 31, 231, 331, 431: First upper sandwiching roller pair
- 32, 232, 332, 432: Second upper sandwiching roller pair
- 33, 35: Fixed roller
- 34, 36: Movable roller
- 40, 240, 340, 440: Support mechanism
- 43, 45, 243, 245, 445: Fixed support member
- 44, 46, 244, 246, 344, 346, 444, 446: Movable support member
- 47, 48, 247, 248, 347, 348, 447, 448: Bracket
- 51, 52: Impelling force transmission mechanism
- 53, 54: Extended arm
- 61, 62, 161: Impelling force adjustment means (switching means)
- 63, 64, 263, 264, 363, 364, 463, 464: Spring (impelling means)
- 65, 66: Driving arm (rotation member)
- 67, 68, 267, 268, 367, 368, 467, 468: Adjustment screw (impelling force adjustment means)
- 69, 69z: Sensor (detection means)
- 171, 455: Handle (operation portion)
- 250, 350: Camshaft
- 251, 252, 351, 352: Cam (operation member)
- 261, 361,: 461 Switching apparatus (switching means)
- 451, 452: Extended portion
- 453: Operation arm (operation member)
- 454: Rotation shaft
- 471, 472: Holding member (sensor)
- α, β: Deflection angle
- F, R: Transport direction

## Claims

1. An apparatus for position control of a flexible substrate in a vertical direction in a processing apparatus that transports a strip-shaped flexible substrate in a vertical orientation and in a horizontal direction and that performs processing of the substrate on a path of the transport, wherein
first and second upper sandwiching roller pairs which can send the flexible substrate while sandwiching an upper edge thereof are provided,
rotation shafts of the first upper sandwiching roller pair are each inclined such that the rotation direction in a sandwiching portion has a deflection angle directed obliquely upward with respect to a first transport direction of the flexible substrate, and
rotation shafts of the second upper sandwiching roller pair are each inclined such that the rotation direction in a sandwiching portion has a deflection angle directed obliquely upward with respect to a second transport direction opposite the first transport direction,
the apparatus for position control of a flexible substrate further comprising:
a support mechanism, which rotatably supports each of the first and second upper sandwiching roller pairs, and which provides support such that one roller configuring each of the roller pair can be moved to be in contact with or apart from the other roller;
impelling means for imparting a clamping force to each of the roller pairs via the support mechanism; and
switching means for switching the first and second upper sandwiching roller pairs between operative/inoperative states by causing the second upper sandwiching roller pair to withdraw during the transport in the first transport direction and causing the first upper sandwiching roller pair to withdraw during the transport in the second transport direction.

2. The apparatus for position control of a flexible substrate according to Claim 1, wherein the impelling means comprises: first and second springs inserted in the support mechanism correspondingly to the first and second upper sandwiching roller pairs; and impelling force adjustment means for displacing support points of each of the springs so as to adjust the clamping forces of each of the upper sandwiching roller pairs.

3. The apparatus for position control of a flexible substrate according to Claim 2, wherein
the impelling force adjustment means comprises: a transmission mechanism which transmits the impelling forces of each of the springs to the support mechanism as torques; and a rotating member which induces angular displacement of the support points of each of the springs about the connection points with the transmission mechanism, and wherein
the rotating member also serves as the switching means by including angular positions, at which the sandwiching roller pairs are caused to withdraw, as the angular displacements of the support points by the rotating member.

4. The apparatus for position control of a flexible substrate according to Claim 2, wherein
the switching means comprises an operation member which can be alternately attached to and detached from the movable portion of the support mechanism corresponding to operations of contact/apart movement of the first and second upper sandwiching roller pairs, and
through rotation or reciprocal motion of the operation member, the first and second upper sandwiching roller pairs are alternately caused to withdraw opposing to the impelling forces of the first and second springs.

5. The apparatus for position control of a flexible substrate according to Claim 3 or 4, wherein the switching means further comprises: an operation portion for an operator to use to manually operate the rotating member or the operation member; and holding means for holding the rotating member or the operation member at each switching position.

6. The apparatus for position control of a flexible substrate according to Claim 5, wherein the switching means further comprises detection means for detecting that the rotating member or the operation member is held at each of the switching positions.

7. The apparatus for position control of a flexible substrate according to any one of Claims 1 to 6, wherein
first and second lower sandwiching roller pairs, which can send the flexible substrate while sandwiching a lower edge thereof are provided,
the first lower sandwiching roller pair is arranged at substantially the same position in a direction of transport of the flexible substrate as the first upper sandwiching roller, and rotation shafts are inclined such that the rotation direction in the sandwiching portion has a deflection angle inclined obliquely downward with respect to the first transport direction, and
the second lower sandwiching roller pair is arranged at substantially the same position in the direction of transport of the flexible substrate as the second upper sandwiching rollers, and rotation shafts are inclined such that the rotation direction in the sandwiching portion has a deflection angle inclined obliquely downward with respect to the second transport direction,
the apparatus for position control of a flexible substrate further comprising:
a support mechanism which rotatably supports each of the first and second lower sandwiching roller pairs and which provides support such that one roller configuring each of the roller pair can be moved to be in contact with or apart from the other roller;
impelling means for imparting a clamping force to each of the roller pairs via the support mechanism; and
switching means for switching the first and second lower sandwiching roller pairs between operative/inoperative states by causing the second lower sandwiching roller pair to withdraw during the transport in the first transport direction and causing the first lower sandwiching roller pair to withdraw during the transport in the second transport direction.

8. An apparatus for position control in a width direction of a flexible substrate in a processing apparatus that transports a strip-shaped flexible substrate and performs processing of the substrate on a path of the transport, wherein
first and second sandwiching roller pairs on each side, which can send the flexible substrate while sandwiching a side edge thereof in a width direction of the substrate are provided,
rotation shafts of the first sandwiching roller pairs on each side are inclined such that a rotation direction in each of sandwiching portions has a deflection angle directed outward from the width direction relative to a first transport direction of the flexible substrate, and
rotation shafts of the second sandwiching roller pairs on each side are inclined such that a rotation direction in each of sandwiching portions has a deflection angle directed outward from the width direction relative to a second transport direction of the flexible substrate opposite the first transport direction,
the apparatus for position control further comprising:
a support mechanism, which rotatably supports each of the first and second sandwiching roller pairs on each side, and which provides support such that one roller configuring each of the roller pair can be moved to be in contact with or apart from the other roller;
impelling means for imparting a clamping force to each of the roller pairs via the support mechanism; and
switching means for switching the first and second upper sandwiching roller pairs between operative/inoperative states by causing the second upper sandwiching roller pair to withdraw during the transport in the first transport direction and causing the first upper sandwiching roller pair to withdraw during transport in the second transport direction.
